# EUROPEAN PATENT APPLICATION

(11) **EP 4 768 877 A1**
(43) Date of publication of application: **01.07.2026**
(21) Application number: 25747870.1
(22) Date of filing: 24.01.2025
(51) Int. Cl.: G01K 3/14

(54) **POWER SUPPLY APPARATUS, ELECTRICAL SYSTEM, AND TEMPERATURE MEASUREMENT METHOD FOR POWER SUPPLY APPARATUS**

(30) Priority: 31.01.2024 US 202463627094 P
(71) Applicant: Delta Electronics, Inc., Taoyuan City 333 (TW)
(72) Inventor: LIU, Hung-hsiao, Taoyuan City 333 (TW); CHENG, Chang-yi, Taoyuan City 333 (TW); SU, Wei-te, Taoyuan City 333 (TW); WU, Chia-chi, Taoyuan City 333 (TW)
(74) Representative: Nederlandsch Octrooibureau
(86) International application number: PCT/CN2025/074870
(87) International publication number: WO 2025/162302

(57) **Abstract**

A power supply apparatus (100) comprises an inverter (110), voltage and current measuring devices (120a, 120b), a temperature sensor (130), and an operation circuit (140). The inverter (110) comprises change-over switches (SW1-SW6). The voltage and current measuring devices (120a, 120b) are configured to measure the voltage (V1) and the current (I1) on the change-over switches (SW1-SW6). The temperature sensor (130) is configured to measure an initial temperature (T[0]) in an initial state. The operation circuit (140) is coupled to the voltage and current measuring devices (120a, 120b) and the temperature sensor (130). The operation circuit (140) is configured to: execute a power model (142), and calculate a first transient power of the change-over switches (SW1-SW6) on the basis of the initial temperature (T[0]), the voltage (V1), and the current (I1); and execute a thermal model (144), and calculate a first transient ideal temperature of the change-over switches (SW1-SW6) on basis of the first transient power. The power supply apparatus (100) calculates, in real time, the transient temperature of channel interfaces of the change-over switches (SW1-SW6) by measuring the voltage (V1) and the current (I1) on the change-over switches (SW1-SW6) of the inverter (110). The present invention also relates to a temperature measurement method (500) for a power supply apparatus, and an electrical system (ES1).

## Description

### BACKGROUND

### Field of Invention

This disclosure relates to a power supply device and a temperature measuring method, and in particular to the cockpit monitoring device and method thereof.

### Description of Related Art

Thermal management systems usually rely on basic thermal models and require manual calibration. Under varying operating conditions, this approach can lead to inefficiencies and possible failures. A temperature measuring device can be configured to measure operating ambient temperature of a circuit device. However, the temperature measuring device is mainly able to measure a steady-state temperature of the circuit device, such as temperature changes every 10 seconds during the continuous operation of the circuit device. The steady-state temperature measurement can only represent an overall operating ambient temperature of the circuit device, and cannot detect a transient temperature of a core circuit in the circuit device at a specific moment (for example, measuring a channel interface temperature of a power switch at the moment of switching).

Since temperature measuring devices cannot measure or calculate the transient temperature of a specific component inside a circuit in real time, this may make temperature monitoring difficult.

### SUMMARY

The present disclosure provides a power supply device. The power supply device comprises an inverter, a voltage current measuring device, a temperature sensor and a computing circuit. The inverter comprises a switch. The voltage current measuring device is configured to measure a voltage and a current on the switch. The temperature sensor is configured to measure an initial temperature in an initial phase. The computing circuit is coupled to the voltage current measuring device and the temperature sensor, and the computing circuit is configured to: execute a power model to calculate to obtain a first transient power of the switch based on the initial temperature, the voltage of the switch, and the current; and execute a thermal model to calculate to obtain a first transient ideal temperature based on the first transient power of the switch.

The present disclosure provides a temperature measuring method for a power supply device. The power supply device comprises an inverter, a voltage current measuring device, a temperature sensor and a computing circuit. The inverter comprises a switch. The temperature measuring method comprises: by the voltage current measuring device, measuring a voltage and a current on the switch; by the temperature sensor, measuring an initial temperature in an initial phase; by the computing circuit, executing a power model to calculate a first transient power of the switch based on the initial temperature, and the voltage and the current of the switch; and by the computing circuit, executing a thermal model to calculate a first transient ideal temperature of the switch based on the first transient power.

The present disclosure provides an electrical system. The electrical system comprises a working unit and a surrounding circuit. The working unit comprises a core position. The working unit is configured to generate an output energy according to an input energy. The surrounding circuit corresponds to the working unit. A temperature change and a time relationship between the core position of the electrical system and the surrounding circuit correspond to a thermal impedance function. The electrical system estimates a thermal system parameter of the core position by a temperature data of the surrounding circuit and the thermal impedance function.

In summary, the power supply device of the present disclosure can just measure the switch voltage and the current on the switch of the inverter, and then instantly calculate to obtain the transient temperature on the switch in real time.

### BRIEF DESCRIPTION OF THE DRAWINGS

Fig. 1 is a schematic diagram of an electrical system according to an embodiment of the present disclosure.
Fig. 2 is a temperature curve diagram of the core position and the surrounding circuit according to the embodiment of Fig. 1.
Fig. 3 is a schematic diagram of an electrical system according to an embodiment of the present disclosure.
Fig. 4 is a schematic diagram of a power supply device according to an embodiment of the present disclosure.
Fig. 5 is a schematic diagram of a computing circuit according to the embodiment of Fig. 4.
Fig. 6 is a curve diagram of temperature and power related to the power model according to the embodiment of Fig. 5.
Fig. 7 is a curve diagram related to the thermal model in the embodiment of Fig. 5.
Fig. 8 is a flow chart of a temperature measuring method according to an embodiment of the present disclosure.

### The symbols in the figures:

ES1, ES2: electrical system
WU1, WU2 : working unit
OC1, OC2 : surrounding circuit
CRP1, CRP2: core position
P_in, P_in1, P_in2 : input energy
P_out, P_out1, P_out2 : output energy
100: power supply device
110: inverter
SW1, SW2, SW3, SW4, SW5, SW6: switch
120a: voltage measuring device
120b: current measuring device
130: temperature sensor
140: computing circuit
SC1, SC2: cable
GND : ground terminal
C1, C2, C3, C4, C5, C6: capacitor
CID1, CID2: coupled inductor
MOT1: motor
V1: voltage
I1: current
T[0] : initial temperature
T[1]-T[n]: operating ambient temperature
142: power model
142a : estimating unit
142b: integrating unit
144: thermal model
Eon: on-state switching power loss
Eoff: turn-off switching power loss
Erec: reverse recovery loss power
Vcond: switch conducting voltage
TP[1]-TP[n] : transient power
TTI[1]-TTI[n]: transient ideal temperature
t1,t2,t3,t4 : time point
500: temperature measuring method
S510, S520, S530, S540: step

### DETAILED DESCRIPTION

The embodiments are described in detail below with reference to the appended drawings to better understand the aspects of the present disclosure. In the figures, the same reference numerals represent the same or similar components or method flows.

### An electrical system

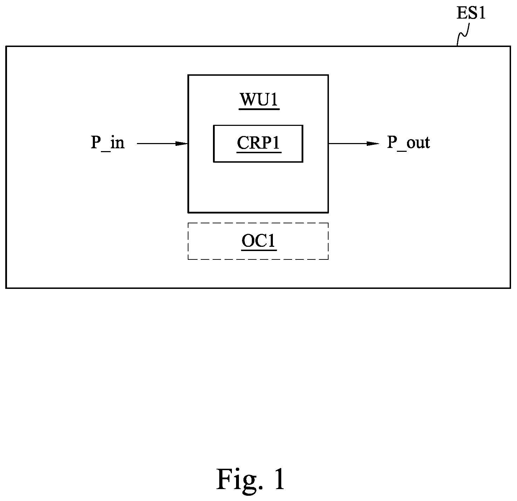

Referring to Fig. 1, Fig. 1 is a schematic diagram of an electrical system ES1 according to an embodiment of the present disclosure. In the embodiment of Fig. 1, the electrical system ES1 comprises a working unit WU1 and a surrounding circuit OC1 (in some embodiments, the surrounding circuit OC1 refers to a peripheral circuit located near the working unit WU1), the working unit WU1 comprises a core position CRP1, and the surrounding circuit OC1 corresponds to the working unit WU1. The electrical system ES1 can receive an input energy P_in and generate an output energy P_out according to the input energy P_in.

### Embodiment of establishing a thermal system parameter

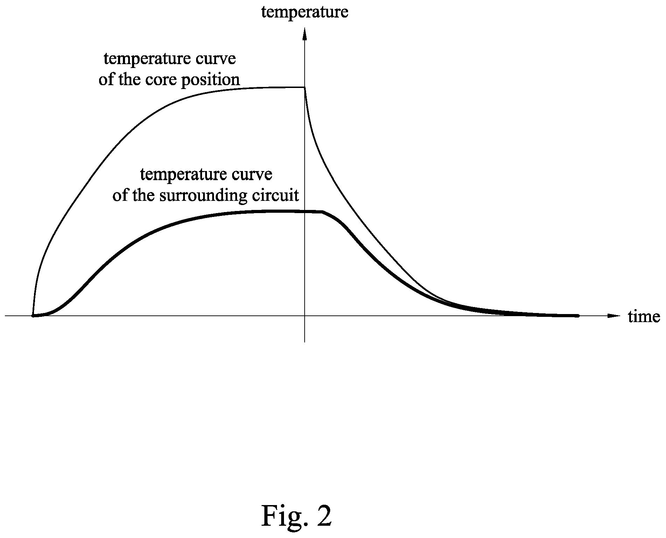

Referring to Fig. 2, Fig. 2 is a temperature curve diagram of the core position CRP1 and the surrounding circuit OC1 according to the embodiment of Fig. 1. In this embodiment, the input energy P_in of the electrical system ES1 comprises a heat energy input, and the core position CRP1 of the working unit WU1 is heated to increase the temperature until the heat energy input generated by the input energy P_in and the heat energy output generated by the output energy P_out of the core position CRP1 reach a balance, so that the core position CRP1 and the surrounding circuit OC1 reach a steady-state temperature. And then, the input energy P_in is reduced or stopped, and the core position CRP1 and the surrounding circuit OC1 begin to cool down, thereby obtaining the temperature change and the time relationship of the core position CRP1 and the surrounding circuit OC1 in Fig. 2. Through the temperature change and the time relationship of the core position CRP1 and the surrounding circuit OC1 through the thermal impedance curve conversion, the thermal impedance function can be further obtained to establish the thermal system parameter.

In the embodiment mentioned above, transient voltage changes at the measurement point of the object to be tested can be captured by using the JEDEC 51-14 test method or in conjunction with thermocouple wires. This technology converts voltage data into temperature rise data, thereby obtaining the time-thermal resistance relationship and the thermal resistance-heat capacity relationship of the object to be tested. These relationships are configured for dynamic monitoring to obtain the electrical system ES1 thermal impedance function or establish the thermal system parameter.

### Embodiment of an electrical system parameter

In one embodiment, the input energy P_in of the electrical system ES1 comprises the electrical energy input, and the operating condition of the working unit WU1 is controlled with respect to the key electrical characteristic of the working unit WU1. Under the control of the operating condition of the working unit WU1, the working unit WU1 can output the output energy P_out. By establishing the relationship between the key electrical characteristic and the operating condition of the working unit WU1, the electrical system parameter can be established.

In this embodiment, the electrical system ES1 can be any device configured to transfer or convert mechanical energy and electrical energy. The electrical system ES1 may exhibit thermal characteristics during the energy transfer or conversion process. Therefore, the electrical system ES1 can establish the thermal system parameter by the temperature change and the time relationship at the core position CRP1 and the peripheral position OC1 and by converting the thermal impedance curve to obtain the thermal impedance function. When the electrical system ES1 is operating, the transient thermal resistance and temperature of the core position CRP1 of the electrical system ES1 can be estimated by sensing the temperature of the surrounding circuit OC1 and the thermal impedance function of the electrical system ES1. Therefore, this embodiment can provide multiple reference values, and these reference values can be transient thermal resistance detection of the core position CRP1, core position CRP1 temperature detection, component overheat protection, and/or control parameters of the working unit WU1 when the electrical system ES1 is operating.

In other words, the electrical system ES1 may perform overheat protection on the working unit WU1 according to the thermal system parameter of the core position CRP1 and/or use the thermal system parameter as a control parameter.

In this embodiment, the dynamic temperature of the core position CRP1 of the working unit WU1 can be measured, for example, by monitoring the change in junction voltage of the semiconductor device under forward bias operation. Therefore, the electrical system ES1 can estimate the transient thermal resistance of the core position CRP1 and the dynamic temperature measurement of the core position CRP1 by temperature sensing of the surrounding circuit OC1 and the thermal impedance function of the electrical system ES1, and further evaluate the degradation of a physical state of the core position CRP1 of the working unit WU1 by evaluating the transient thermal resistance displacement.

In the embodiment mentioned above, the degradation of the physical state of the core position CRP1 of the working unit WU1 can be evaluated by comparing the thermal system parameter with the temperature data of the surrounding circuit OC1 through the thermal impedance function and referring to the electrical system parameter.

### Embodiment of the transient thermal resistance displacement

In the embodiment mentioned above, when the system configuration of the electrical system ES1 is changed, for which the thermal system parameters and the electrical system parameters have been obtained, a Computer Aided Engineering (CAE) simulation can be performed based on the difference in the system configuration change of the electrical system ES1 to obtain the thermal system parameters and the electrical system parameters of the electrical system ES1 after the configuration change.

In the embodiment mentioned above, by comparing the thermal impedance function with the temperature data of the surrounding circuit OC1, and referring to the working condition of the working unit WU1, and comparing the thermal system parameters obtained by the computer-aided engineering with the electrical system parameters, the transient thermal resistance displacement can be evaluated, and the degradation of the working unit WU1 can be estimated.

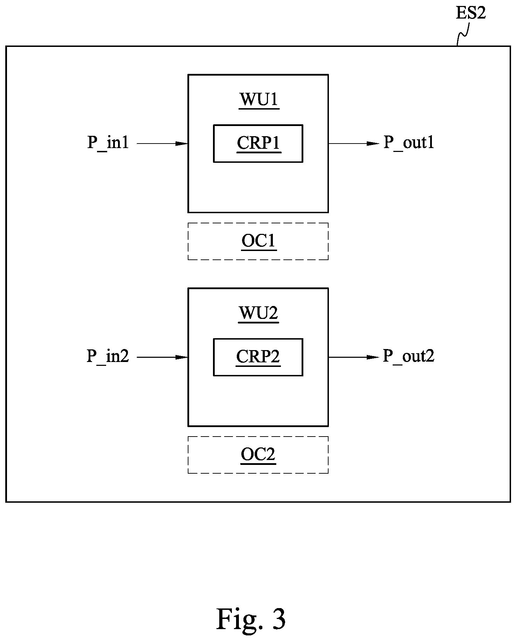

Referring to Fig. 3, Fig. 3 is a schematic diagram of an electrical system ES2 according to an embodiment of the present disclosure. The electrical system ES2 has a working unit WU1, and the working unit WU1 of the electrical system ES2 has the thermal system parameter and the electrical system parameter of the electrical system ES1 in Fig. 1. When the working unit WU1 of the electrical system ES2 is replaced by the working unit WU2, a computer-aided engineering (CAE) simulation can be performed based on the difference between the working unit WU1 and the working unit WU2 to obtain the thermal system parameter and the electrical system parameter of the electrical system ES2 replaced by the working unit WU2.

In this embodiment, input energy P_in1 and P_in2 of the electrical system ES2 both comprise an electrical energy input, and respectively control operating conditions of key electrical characteristics of the working units WU1 and WU2.

Under the control of the operating condition of the working unit WU1, the working unit WU1 can output the output energy P_out1, and the working unit WU2 can output the output energy P_out2. By establishing the relationship between the key electrical characteristics and the operating conditions of the working units WU1 and WU2, the electrical system ES2 can establish electrical system parameters.

In the present embodiment, the electrical system ES2 may be various energy transfer or energy conversion devices for mechanical energy and electrical energy. The electrical system ES2 may have thermal characteristics during the energy transfer or energy conversion process; therefore, the temperature change and the time relationship of the core position CRP1, CRP2 and the surrounding circuit OC1, OC2 (in some embodiments, the surrounding circuit OC2 refers to the peripheral circuit located near the working unit WU2, and the circuit of the surrounding circuit OC2 is different from the circuit of the surrounding circuit OC1) can be obtained through the thermal impedance curve conversion to obtain the thermal impedance function, and establish the thermal system parameter. When the electrical system ES2 is operated, the transient thermal resistance and the temperature of the core position CRP1, CRP2 of the electrical system ES2 can be estimated through the temperature sensing of the surrounding circuit OC1, OC2 and the thermal impedance function of the electrical system ES2. Therefore, the present embodiment can provide a plurality of reference values, and these reference values can be transient thermal resistance detection of the core position CRP1, transient thermal resistance detection of core position CRP2, core position CRP1 temperature detection, core position CRP2 temperature detection, component overheat protection, control parameters of working unit WU1, and control parameters of working unit WU2 when electrical system ES2 is operating.

In this embodiment, the dynamic temperature of the core position CRP1 of the working unit WU1 can be measured. Therefore, the electrical system ES2 can estimate the transient thermal resistance of the core position CRP1 through the temperature sensing of the surrounding circuit OC1 and the thermal impedance function of the electrical system ES2 and a dynamic temperature measurement of the core position CRP1 corresponding to temperature, and evaluate the transient thermal resistance displacement to further evaluate the aging degree of one of the physical states of the core position CRP1 of the working unit WU1.

In addition, the dynamic temperature of the core position CRP2 of the working unit WU2 can be measured. Therefore, the electrical system ES2 can estimate the transient thermal resistance of the core position CRP2 through the temperature sensing of the surrounding circuit OC2 and the thermal impedance function of the electrical system ES2, and the temperature control core position CRP2 dynamic temperature measurement, and evaluate the transient thermal resistance displacement to further evaluate the degradation of one of the physical states of the core position CRP2 of the working unit WU2.

In one embodiment, the electrical system ES2 may further comprise a plurality of working units. According to this embodiment, the electrical system ES2 may comprise thermal system parameters and electrical system parameters of the plurality of working units.

In this embodiment, the plurality of working units of the electrical system ES2 may include the working units WU1 and WU2. The working unit WU1 and the working unit WU2 may obtain the thermal system parameters and the electrical system parameters respectively according to the above embodiments. The electrical system ES2 comprising the working unit WU1 and the working unit WU2 may be subjected to computer-aided engineering simulation according to the differences between the working units to obtain the thermal system parameters and the electrical system parameters of the electrical system ES2 comprising both the working units WU1 and WU2.

### Embodiment related to inverter

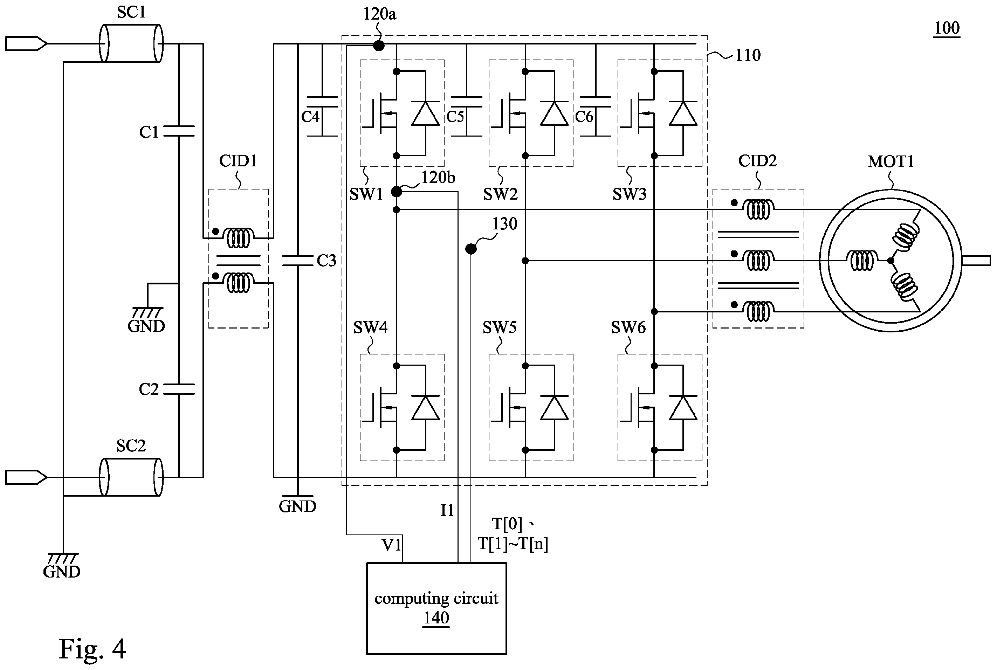

Referring to Fig. 4, Fig. 4 is a schematic diagram of a power supply device 100 according to an embodiment of the present disclosure. The working unit WU1 in Fig. 1 corresponds to the remaining circuits of the power supply device 100 in Fig. 3, excluding a motor MOT1. In Fig. 3, the power supply device 100 comprises at least an inverter 110, a voltage measuring device 120a, a current measuring device 120b, a temperature sensor 130, and a computing circuit 140. Furthermore, the power supply device 100 may comprise cables SC1 and SC2, coupled inductors CID1 and CID2, capacitors C1-C6, and the motor MOT1.

In one embodiment, the inverter 110 of the power supply device 100 comprises switches SW1-SW6. The main function of the inverter 110 is to convert direct current input into alternating current output of a specific specification.

In one embodiment, the power supply device 100 can be configured in a power supply system of an electric vehicle (as shown in the embodiment of Fig. 4, to power the motor MOT1). However, the present disclosure is not limited thereto, and the power supply device 100 can also be configured in a renewable energy system (e.g., solar energy or wind energy) or a power supply device based on direct current (e.g., a battery) feeding power to an alternating current grid. In these examples, the load may be replaced by an alternating current grid (not shown) or other similar alternating current power loads instead of the motor MOT1 shown in Fig. 4. The inverter 110 is configured to convert direct current power input (e.g., a battery, a solar panel, a wind turbine) into specific alternating current power output.

In one embodiment, the switches SW1-SW6 may be switching elements such as insulated gate bipolar transistors (IGBT) or metal oxide semiconductor field effect transistors (MOSFET). The computing circuit 140 is configured to generate gate signals to drive the switches SW1-SW6, thereby controlling the operations of the switches SW1-SW6. The switches SW1-SW6 switch their switching states according to the gate signals to generate a three-phase AC power. The switches SW1-SW6 are controlled by precise switching operations to generate waveforms of required frequency and voltage. Three groups of switches SW1-SW6 form a three-phase system, and each group controls the voltage of one phase, thereby forming a balanced three-phase AC power. The output frequency can be adjusted by adjusting the switching speed of switches SW1-SW6 to control the motor speed (e.g., the rotational speed of motor MOT1). Precise switch controlling operation can minimize the energy loss and improves system efficiency. In addition, when the computing circuit 140 determines that the switches SW1-SW6 are abnormal (e.g., transient temperature is too high, service life is insufficient), the computing circuit 140 can quickly cut off current by shutting down the switches SW1-SW6 to protect the system from damage caused by overload or malfunction. The coordinated operation of the switches SW1-SW6 can ensure that the inverter 110 can operate stably and efficiently.

In one embodiment, the computing circuit 140 of the present case controls and performs over-temperature protection on the switches SW1-SW6 by monitoring/estimating the transient temperature of the respective channel interfaces of the switches SW1-SW6 of the inverter 110. In this embodiment, the switches SW1-SW6 in Fig. 4 may be equivalent to the core position CRP1 of Fig. 1. As described above, the temperature change of the switches SW1-SW6 may be known through the temperature curve of the core position CRP1 in Fig. 2. In addition, the following embodiments will also explain in detail how the computing circuit 140 of the present case monitors/estimates the transient temperature and the specific method of the subsequent over-temperature protection.

In one embodiment, the cables SC1 and SC2 can receive an input voltage and be coupled to the ground terminal GND. The cable SC1 can also be coupled to a first terminal of the capacitor C1. The first terminal of the capacitor C1 is coupled to the ground terminal GND and a first terminal of the capacitor C2. The cable SC2 can also be coupled to a second terminal of the capacitor C2. In one embodiment, the cables SC1 and SC2 can be shielded cables having surfaces coated with insulating materials.

The first input terminal of coupled inductor CID1 is coupled to the first terminal of capacitor C1. The first output terminal of the coupled inductor CID1 is coupled to the first terminal of the capacitor C3 and the first terminal of the capacitor C4. The second input terminal of the coupled inductor CID1 is coupled to the second terminal of the capacitor C2. The second output terminal of the coupled inductor CID1 is coupled to the second terminal of the capacitor C3 and the ground terminal GND. The second terminal of the capacitor C4 is coupled to the ground terminal GND.

As shown in Fig. 4, the capacitor C5 and the capacitor C6 may also be disposed in the inverter 110. A first terminal of the switch SW1 is coupled to the capacitor C4, the capacitor C5, a first terminal of the switch SW2, the capacitor C6, and a first terminal of the switch SW3. A second terminal of the switch SW1 is coupled to a first terminal of the switch SW4. A second terminal of the switch SW2 is coupled to a first terminal of the switch SW5. A second terminal of the switch SW3 is coupled to a first terminal of the switch SW6. A second terminal of the switch SW4, a second terminal of the switch SW5, and a second terminal of the switch SW6 are all coupled to the ground terminal GND.

The measuring terminal of the voltage measuring device 120a can be disposed within the inverter 110, for example, at the first terminal of the switch SW1, to measure voltage V1 across the switch SW1. The measuring terminal of the current measuring device 120b can be disposed within the inverter 110 (i.e., at the second terminal of the switch SW1) to measure the current I1 flowing through the switch SW1. The measuring terminal of the temperature sensor 130 can be disposed within the inverter 110 to measure the initial temperature T[0] of the inverter 110 at the moment of operation (also called the "initial phase") and the operating ambient temperature T[1] to T[n] after the inverter 110 has operated for a period of time. Here, the "n" can be any positive integer greater than 1, representing the amount of times the temperature sensor 130 measures the inverter 110 during its operation, and it can also represent the amount of operating ambient temperatures measured by temperature sensor 130 from the inverter 110. In some embodiments, the measuring terminal of the temperature sensor 130 may also be disposed outside the inverter 110, and the present disclosure is not limited thereto.

The inverter 110 is coupled to the input terminal of the coupled inductor CID2. The three-phase input terminal of the motor MOT1 is coupled to the output terminal of the coupled inductor CID2.

Computing circuit 140 is coupled to the voltage measuring device 120a, the current measuring device 120b, and the temperature sensor 130. The computing circuit 140 receives the voltage V1 through the voltage measuring device 120a, receives the current I1 through the current measuring device 120b, and receives the initial temperature T[0] and the operating ambient temperatures T[1]-T[n] through the temperature sensor 130.

### Embodiment of wafer temperature estimation-timely protection

In one embodiment, the computing circuit 140 of Fig. 4 may execute the power model 142 and the thermal model 144 to calculate to obtain the transient ideal temperature TTI[1]-TTI[n].

In the initial phase, the computing circuit 140 may receive the initial temperature T[0] through the temperature sensor 130. The computing circuit 140 may execute the power model 142 and calculate to obtain the transient power TP[1] based on the initial temperature T[0], the voltage V1 measured by the voltage measuring device 120a in the initial phase, and the current I1 measured by the current measuring device 120b in the initial phase. After calculating the transient power TP[1], the computing circuit 140 may then execute the thermal model 144 and calculate to obtain the transient ideal temperature TTI[1] of the switch SW1 based on the transient power TP[1].

After the initial phase, the power supply device 100 can continue to operate, and the temperature in the inverter 110 may increase over time. The thermal resistance of the switch SW1 may change with the temperature increasing, thereby changing the voltage V1 and the current I1 on the switch SW1. When the power supply device 100 is operating, the computing circuit 140 can first receive the initial temperature T[0] through the temperature sensor 130, and then execute the power model 142 to calculate to obtain the transient power TP[2] of the switch SW1 according to the transient ideal temperature TTI[1], the voltage V1 measured in real time by the voltage measuring device 120a, and the current I1 measured in real time by the current measuring device 120b. After obtaining the transient power TP[2], the computing circuit 140 may then execute the thermal model 144 and calculate to obtain the transient ideal temperature TTI[2] of the switch SW1 based on the transient power TP[2].

Next, the computing circuit 140 may continue to execute the power model 142 and the thermal model 144, and calculate to obtain the transient ideal temperature TTI[3] based on the voltage V1, the current I1, and the transient ideal temperature TTI[2]. The computing circuit 140 may continuously iterate according to the above operations, and calculate to obtain the temperature value of switch SW1 at a certain time point based on the voltage V1 and the current I1 of the switch SW1 at that time point.

In summary, according to the power model 142 and the thermal model 144, the power supply device 100 can instantly calculate to obtain the transient temperature of the switch SW1 by only measuring the voltage V1 and the current I1 on the inverter switch SW1.

In addition to the aforementioned functions, in the embodiment of Fig. 4, the computing circuit 140 of the power supply device 100 can further compare the transient ideal temperature of the switch SW1 with the operating ambient temperature measured by the temperature sensor at a certain time point after the power supply device 100 operates from the initial phase to the time point, and then determine whether the switch SW1 is abnormal.

The computing circuit 140 can calculate to obtain the transient ideal temperature of the switch SW1 at the time point mentioned above through the power model 142 and the thermal model 144. The computing circuit 140 can receive the operating ambient temperature measured by the temperature sensor 130 at the time point. In addition, the computing circuit 140 can set a conduction function, and the conduction function is determined according to the distance between the switch SW1 and the measuring terminal of the temperature sensor 130, and the thermal conductivity of the conductive medium (such as air, heat pipe or heat conductive metal sheet, etc.) between the switch SW1 and the measuring terminal. The computing circuit 140 can convert the operating ambient temperature into the switch operating temperature of the switch SW1 according to the conduction function. In other words, the computing circuit 140 can estimate the switch operating temperature of the switch SW1 according to the conduction function and the operating ambient temperature. The computing circuit 140 can compare the switch operating temperature and the transient ideal temperature of the switch SW1, and then determine whether the switch SW1 is abnormal at that time point.

When the difference value between the switch operating temperature and the transient ideal temperature is greater than a first threshold, it means that the switch SW1 has degraded, resulting in a larger thermal resistance. In this case, the computing circuit 140 can send a control signal to reduce the current I1 flowing through the switch SW1, thereby allowing that the switch SW1 to enter a load reduction mode to extend the service life of the switch SW1.

When the difference value between the switch operating temperature and the transient ideal temperature is greater than the second threshold, it means that the switch SW1 has been over-degraded. Continued use of switch SW1 could cause the entire power supply device 100 to malfunction. In this embodiment, the second threshold is higher than the first threshold. In this situation, computing circuit 140 should send the control signal to shut down the switch SW1 (or the entire inverter 110) or cause the switch SW1 to supply a zero-sequence current to motor MOT1. In some embodiments, when the computing circuit 140 detects this phenomenon, it can generate and send an warning message (such as a description text, a pattern, an alarm sound) to a display, a speaker, or other output interface. This notifies users or maintenance personnel of the current aging of switch SW1, allowing them to perform targeted repairs or maintenance.

In the embodiment mentioned above, when the difference value between the switch operating temperature and the transient ideal temperature becomes greater, it may also mean that the switches SW1-SW6 may be degraded or have insufficient service life. For example, the "rainflow counting algorithm" may be executed to estimate the service life of the switches SW1-SW6 according to a deviation of the operating temperature of the switches SW1-SW6. When it is determined that the service life of the switches SW1-SW6 is insufficient, the maintenance personnel may be prompted to replace them. In some embodiments, the service life of a specific switch among the six switches can be distinguished and a replacement prompt can be issued in a targeted manner.

In the above embodiment, for simplicity, the switch SW1 in the inverter is configured as an example. In one embodiment, the computing circuit 140 can receive the voltage across and current through each of the switches SW2-SW6 to perform transient temperature estimation and over-temperature monitoring for each of these switches. In another embodiment, the computing circuit 140 can simultaneously monitor each of the switches SW1-SW6 and select the highest transient temperature obtained by the computing circuit 140 from these switches to determine whether the inverter 110 is overheated.

Furthermore, in one embodiment, the computing circuit 140 can simultaneously perform transient temperature estimation and over-temperature monitoring on one or more of the switches SW1-SW6.

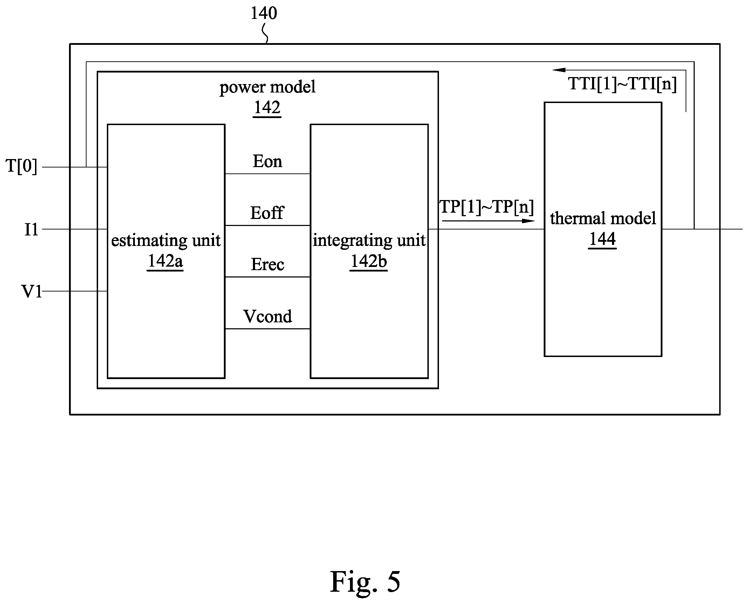

Referring to Fig. 5, Fig. 5 is a schematic diagram of a computing circuit 140 according to the embodiment of Fig. 4. Specifically, Fig5 records the power model 142 and the thermal model 144 of the computing circuit 140.

In the embodiment of Fig. 5, the power model 142 comprises an estimating unit 142a and an integrating unit 142b.

In the initial phase, the estimating unit 142a can estimate an on-state switching power loss Eon, a turn-off switching power loss Eoff, a reverse recovery loss power Erec, and a switch conducting voltage Vcond of the switch SW1 according to the initial temperature T[0], the voltage V1 of the switch SW1, and the current I1.

The switching power loss Eon refers to the power loss when the switch SW1 switches from the off state to the on state. By detecting the changes in the voltage V1 and the current I1 when the switch SW1 switches to the on state, the on-state switching power loss Eon can be obtained.

The power loss Eoff is the power loss when the switch SW1 switches from the on state to the off state. By detecting the changes in the voltage V1 and the current I1 when the switch SW1 switches to the off state, the turn-off switching power loss Eoff can be obtained.

Regarding the reverse recovery loss power Erec, when the voltage V1 applied to the switch SW1 changes from forward to reverse, the switch SW1 may not shut down immediately. The switch SW1 needs a period of time to switch from the on state to the off state, which is called the reverse recovery time. During the reverse recovery time, the current I1 may flow in the opposite direction to form a reverse recovery current. By measuring the values of the voltage V1 and the current I1 during the reverse recovery time, the reverse recovery loss power Erec of the switch SW1 can be obtained.

The switch conducting voltage Vcond refers to the conduction voltage that makes the switch SW1 enter the conduction state.

In this embodiment, the integrating unit 142b may receive the on-state switching power loss Eon, the turn-off switching power loss Eoff, the reverse recovery loss power Erec, and the switch conducting voltage Vcond from the estimating unit 142a, and calculate to obtain the transient power TP[1] according to the received values.

The thermal model 144 may receive the transient power TP[1] from the integrating unit 142b, and calculate to obtain the transient ideal temperature TTI[1] based on the transient power TP[1].

After the initial phase, the thermal model 144 can transmit the transient ideal temperature TTI[1] to the power model 142. The power model 142 can correspondingly output the transient power TP[2] to the thermal model 144, so that the thermal model 144 can calculate to obtain the transient ideal temperature TTI[2]. Similarly, the computing circuit 140 can continue to calculate to obtain the transient ideal temperature TTI[3]-TTI[n].

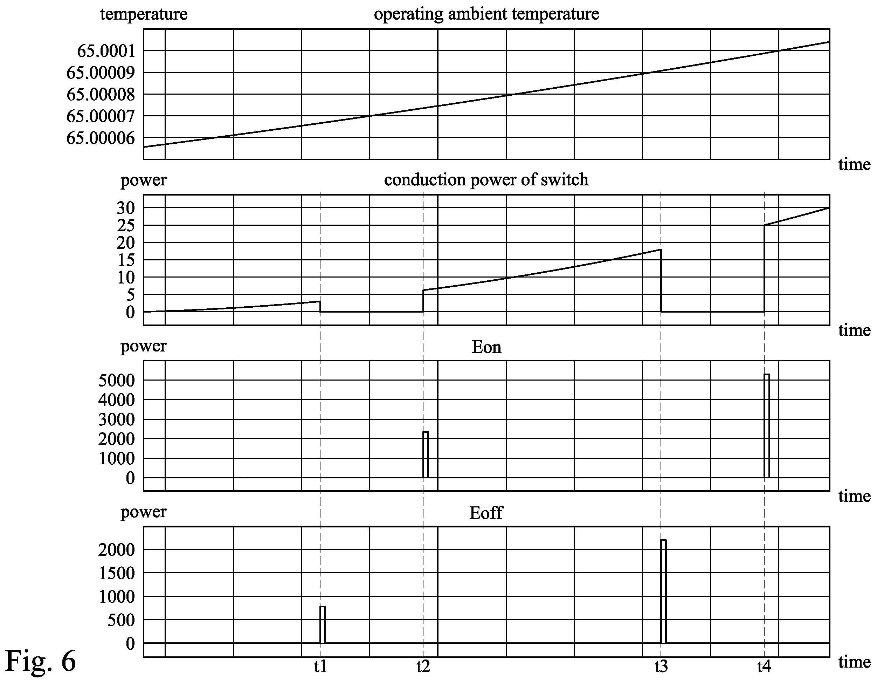

Referring to Fig. 6, Fig. 6 is a curve diagram of temperature and power related to the power model 142 according to the embodiment of Fig. 5.

As can be seen from Fig. 6, the operating temperature of the power supply device 100 increases over time, and the values of the operating ambient temperatures T[1]-T[n] also gradually increase accordingly.

Before the time point t1, the conduction power of the switch SW1 increases with the temperature of the power supply device 100. Between the time point t1 and the time point t2, since the switch SW1 is in the off state, the conduction power of switch SW1 returns to zero. Between the time point t2 and the time point t3, the switch SW1 returns to the on state, and its conduction power increases with the temperature of power supply device 100. Between the time point t3 and the time point t4, the switch SW1 turns off again, and the conduction power of the switch SW1 returns to zero. After the time point t4, the switch SW1 returns to the on state again, and its conduction power increases with the temperature of the power supply device 100.

At the time points t1 and t3, the switch SW1 switches from the on state to the off state, thereby generating the turn-off switching power loss Eoff. At the time points t2 and t4, the switch SW1 switches from the off state back to the on state, thereby generating the on-state switching power loss Eon.

It should be noted that, in one embodiment, the power model 142 is established based on the measurement results in the laboratory, that is, a use environment equivalent to the power supply device 100 is constructed in the laboratory environment, and the on-state switching power loss Eon, the turn-off switching power loss Eoff, the reverse recovery loss power Erec and the switch conducting voltage Vcond corresponding to the switch SW1 under different conduction voltages and conduction currents are measured one by one while controlling the ambient temperature, so as to obtain various power characteristics of the switch SW1 under different conduction voltages and conduction currents at a specific ambient temperature. In some embodiments, these power characteristics are recorded as a comparison table or as a database model to obtain the power model 142.

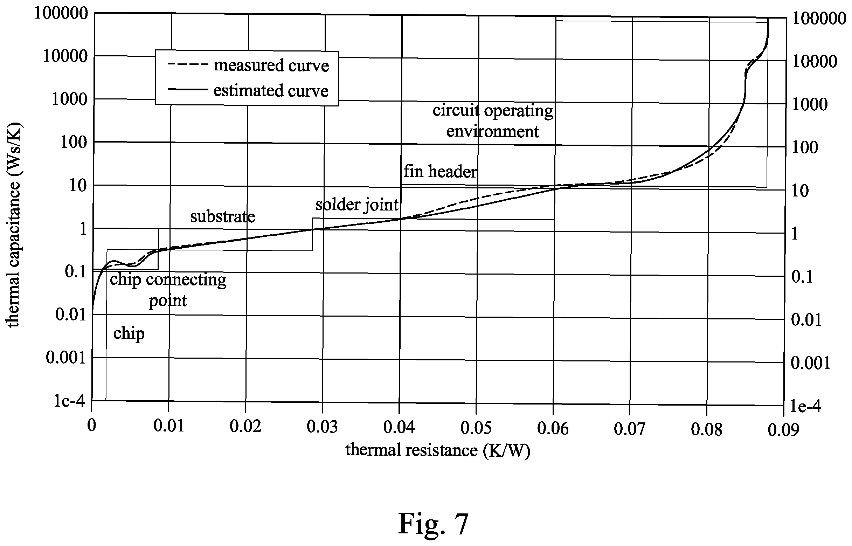

Referring to Fig. 7, Fig. 7 is a curve diagram related to the thermal model 144 in the embodiment of Fig. 5. The curve diagram of Fig. 7 comprises a measured curve and an estimated curve, which the measured curve and the estimated curve bath can represent the relationship between the thermal resistance of switch SW1 and the thermal capacitance of switch SW1.

In Fig. 7, the measured curve is a preset curve. The preset curve is obtained by measuring the thermal resistance and thermal capacitance of the chip, substrate, solder joint, fin header, and circuit operating environment used in the power supply device 100.

Referring to the measurement curve of Fig. 7, the thermal model 144 can convert the transient power TP[1]-TP[n] into the transient ideal temperature TTI[1]-TTI[n] one by one, and draw the measurement curve of Fig. 7.

By comparing the positional relationship between the measured curve and the measured curve in Fig. 7, it is possible to more intuitively understand whether switch SW1 of the power supply device 100 is abnormal.

It should be noted that, in one embodiment, the thermal model 144 is established based on the measurement results in the laboratory, that is, a use environment equivalent to the power supply device 100 is constructed in the laboratory environment, and the cross-voltage of the switch SW1 is measured one by one under the condition of controlling the ambient temperature and the fixed conduction current, and then the power loss of the switch SW1 is reversely inferred from the conduction current and the cross-voltage. In some embodiments, the relationship between the power loss and the ambient temperature is recorded as a comparison table or as a database model to obtain the thermal model 144.

### Embodiment of predicting maintenance time

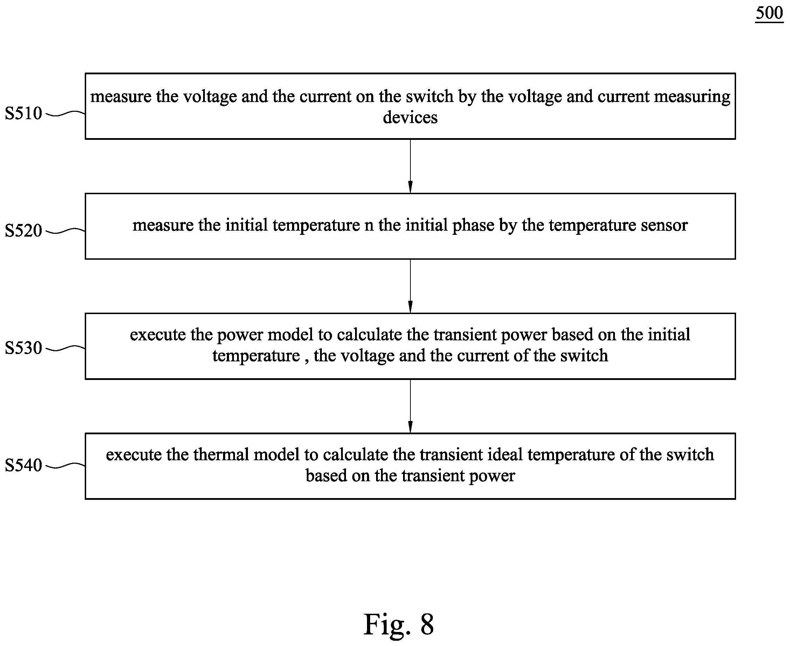

Referring to Fig. 8, Fig. 8 is a flow chart of a temperature measuring method 500 according to an embodiment of the present disclosure. The temperature measuring method 500 is configured to illustrate the operation method of the power supply device 100.

In step S510, the power supply device 100 may measure the voltage V1 and the current I1 on the switch SW1 by the voltage and current measuring devices (i.e., the voltage measuring device 120a and the current measuring device 120b).

In step S520, the power supply device 100 may measure the initial temperature T[0] in the initial phase by the temperature sensor 130.

In step S530, the power supply device 100 may execute the power model 142 to calculate the transient power TP[1] based on the initial temperature T[0], the voltage V1 and the current I1 of the switch SW1.

In step S540, the power supply device 100 may execute the thermal model 144 to calculate the transient ideal temperature TTI[1] of the switch SW1 based on the transient power TP[1]. In this step, the power supply device 100 may also record the thermal system parameter and the electrical system parameter generated by the thermal model 144.

After step S540, the power supply device 100 may receive the transient ideal temperature TTI[1] and continuously calculate to obtain the transient ideal temperature TTI[2]-TTI[n] according to the temperature measuring method 500. In this step, the power supply device 100 may also record multiple sets of thermal system parameters and electrical system parameters, and further record the value changes of the thermal system parameters and the electrical system parameters.

In this embodiment, the power supply device 100 can analyze the numerical changes in thermal and electrical system parameters through numerical fitting, statistical methods, artificial intelligence deep learning, and other methods. Based on these records, it can predict the time point at which inverter 110 will reach degraded. This time point can be replaced with various representations such as "electric vehicle mileage" or "amount of trips," or simply a date and time, and the present disclosure is not limited thereto.

In summary, based on power model 142 and thermal model 144, the power supply device 100 of the present disclosure can instantly calculate to obtain the transient temperature of the switch of the inverter by measuring the voltage and the current on the switch. In addition, in some circumstances, the power supply device 100 of the present disclosure can also determine whether the inverter has degraded by comparing the transient ideal temperature with the ambient temperature when the system is operating.

The above are only preferred embodiments of the present disclosure. Various modifications and variations can be made to the structure of the present disclosure without departing from the scope or spirit of the invention. In view of the foregoing, it is intended that the present invention cover modifications and variations of this invention provided they fall within the scope of the following claims.

## Claims

1. A power supply device, comprising:
an inverter, comprising a switch;
a voltage current measuring device, configured to measure a voltage and a current on the switch;
a temperature sensor, configured to measure an initial temperature in an initial phase; and
a computing circuit, coupled to the voltage current measuring device and the temperature sensor, and the computing circuit is configured to:
execute a power model to calculate to obtain a first transient power of the switch based on the initial temperature, the voltage of the switch, and the current; and
execute a thermal model to calculate to obtain a first transient ideal temperature based on the first transient power of the switch.

2. The power supply device of claim 1, wherein the computing circuit is further configured to:
execute the power model to calculate to obtain a second transient power of the switch according to the first transient ideal temperature, the voltage, and the current when the power supply device is operating; and
execute the thermal model to calculate to obtain a second transient ideal temperature of the switch according to the second transient power.

3. The power supply device of claim 1, wherein the computing circuit is further configured to:
measure an operating ambient temperature by the temperature sensor when the power supply device is operating;
estimate a switch operating temperature of the switch based on the operating ambient temperature and a transfer function between the switch and the temperature sensor; and
compare the switch operating temperature with the first transient ideal temperature to determine whether the switch is abnormal.

4. The power supply device of claim 3, wherein,
in response to a difference value between the switch operating temperature and the first transient ideal temperature being higher than a first threshold, the computing circuit sends a control signal to reduce the current flowing through the switch; and
in response to the difference value between the switch operating temperature and the first transient ideal temperature being higher than a second threshold, the computing circuit sends the control signal to stop the switch from operating, and the second threshold is higher than the first threshold.

5. The power supply device of claim 1, wherein the power model estimates an on-state switching power loss, a turn-off switching power loss, a reverse recovery loss power, and a switch conducting voltage of the switch according to the initial temperature, and the voltage and the current of the switch, and calculates to obtain the first transient power according to the on-state switching power loss, the turn-off switching power loss, the reverse recovery loss power, and the switch conducting voltage.

6. A temperature measuring method for a power supply device, the power supply device comprises an inverter, a voltage current measuring device, a temperature sensor and a computing circuit, wherein the inverter comprises a switch, the temperature measuring method comprises:
by the voltage current measuring device, measuring a voltage and a current on the switch;
by the temperature sensor, measuring an initial temperature in an initial phase;
by the computing circuit, executing a power model to calculate a first transient power of the switch based on the initial temperature, and the voltage and the current of the switch; and
by the computing circuit, executing a thermal model to calculate a first transient ideal temperature of the switch based on the first transient power.

7. The temperature measuring method of claim 6, further comprising:
obtaining a second transient power of the switch based on the first transient ideal temperature, the voltage and the current when the power supply device is operating; and
executing the thermal model to calculate to obtain a second transient ideal temperature of the switch according to the second transient power.

8. The temperature measuring method of claim 6, further comprising:
measuring an operating ambient temperature by the temperature sensor when the power supply device is operating;
estimating a switch operating temperature of the switch based on the operating ambient temperature and a transfer function between the switch and the temperature sensor; and
comparing the switch operating temperature with the first transient ideal temperature to determine whether the switch is abnormal.

9. The temperature measuring method of claim 8, further comprising:
in response to a difference value between the switch operating temperature and the first transient ideal temperature being higher than a first threshold, sending a control signal to reduce the current flowing through the switch; and
in response to the difference value between the switch operating temperature and the first transient ideal temperature being higher than a second threshold, sending the control signal to stop the switch from operating, and the second threshold is higher than the first threshold.

10. The temperature measuring method of claim 6, wherein the power model estimates an on-state switching power loss, a turn-off switching power loss, a reverse recovery loss power, and a switch conducting voltage of the switch according to the initial temperature, and the voltage and the current of the switch, and calculates to obtain the first transient power according to the on-state switching power loss, the turn-off switching power loss, the reverse recovery loss power, and the switch conducting voltage.

11. An electrical system, comprising:
a working unit, comprising a core position, the working unit is configured to generate an output energy according to an input energy; and
a surrounding circuit, corresponding to the working unit;
wherein a temperature change and a time relationship between the core position of the electrical system and the surrounding circuit correspond to a thermal impedance function,
wherein the electrical system estimates a thermal system parameter of the core position by a temperature data of the surrounding circuit and the thermal impedance function.

12. The electrical system of claim 11, wherein the thermal system parameter of the core position corresponds to a transient thermal resistance.

13. The electrical system of claim 11, wherein the thermal system parameter of the core position corresponds to a temperature.

14. The electrical system of claim 11, wherein the electrical system performs overheat protection of the working unit and/or serves as a control parameter based on the thermal system parameter of the core position.

15. The electrical system of claim 14, wherein the thermal system parameter of the core position corresponds to a transient thermal resistance and temperature.

16. The electrical system of claim 11, wherein the input energy of the electrical system comprises an electrical energy input, and the working unit outputs the output energy under control of an operating condition of the working unit; and
wherein the electrical system establishes an electrical system parameter by establishing a relationship between a key electrical characteristic of the working unit and an operating condition.

17. The electrical system of claim 16, wherein the working unit evaluates a degradation of a physical state of the core position by reference to the thermal system parameter and the electrical system parameter.

18. The electrical system of claim 16, wherein the working unit compares the thermal system parameter by using the thermal impedance function and the temperature data at the surrounding circuit, references an working condition of the working unit, and compares the thermal system parameter obtained by computer-aided engineering with the electrical system parameter to evaluate a transient thermal resistance shift, thereby estimating an aging degree of the working unit.
